# EUROPEAN PATENT SPECIFICATION

(11) **EP 0 298 345 B1**
(45) Date of publication and mention of the grant of the patent: **13.01.1993**
(21) Application number: 88110292.5
(22) Date of filing: 28.06.1988
(51) Int. Cl.: C23C 16/18, C23C 16/04, H01L 21/02, H05K 3/00

(54) **Method for preparing substrates for subsequent electroless metallization**
Verfahren zur Herstellung von Substraten für nachträgliche stromlose Metallisierung
Procédé pour la fabrication de substrats pour métallisation subséquente sans courant

(30) Priority: 10.07.1987 US 72203
(43) Date of publication of application: 11.01.1989
(73) Proprietor: International Business Machines Corporation, Armonk, N.Y. 10504 (US)
(72) Inventor: Clarke, Thomas Carl, Morgan Hill, CA.95 037 (US); Kovac, Caroline Ann, Ridgefield, CT.06 877 (US); Jung, Dae Young, Endwell, N.Y. 13 760 (US); Park, Jae Myung, Mahopac, N.Y.10 541 (US); Thomas, Richard Ronald, Fishkill, N.Y.12 524 (US)
(74) Representative: Mönig, Anton, Dipl.-Ing.

(56) References cited:
- EP-A- 0 182 193
- SOVIET INVENTIONS ILLUSTRATED, section Ch, week 8839, November 09, 1988 DERWENT PUBLICATIONS LTD., London M 13

## Description

The present invention is a method for depositing a metallic seed layer from a vapor of metal compound for use in the deposition of metals on a substrate, for example, in the manufacture of a printed circuit board.

It is well known in the art that certain metals act as seed material for electroless deposition of other metals. For example, palladium is a well known seed material for electroless copper deposition. Often metal patterns, for example conducting lines, are formed on printed circuit boards by depositing or forming a layer of such metal seed on the surface of the printed circuit board, followed by the electroless deposition of a metal forming the conductor onto the seed layer.

In the art, seed layers have been formed by wet or (liquid) or dry processes. In a wet process the surface to be plated is first sensitized. The sensitized surface is exposed to a liquid which contains a homogeneous distribution of a compound or complex of the seed metal. The compound reacts with the sensitized surface. The solvent is removed and the compound either physically adheres to the sensitized surface or a species of the constituent metal of the compound adheres to the surface. The compound adhering to the surface is then transformed to the free metal adhering to the surface. The free metal acts as a seed layer for subsequent electroless deposition of another metal. U.S. Patent No. 4,493,861 to Sirinyan et al. describes such a wet process for forming a metal seed layer.

A dry process for depositing a metal seed layer is described in U.S. Patent No. 4,574,095 to Baum et al. In this process a palladium seed layer is formed for the selective electroless deposition of copper. A substrate is contacted with a vapor of palladium compound. The compound is selectively irradiated with light to cause selective deposition of seeds of palladium on the substrate. Copper is then electrolessly deposited onto the palladium seed. Palladium seed is selectively deposited onto the substrate by first depositing onto the substrate a resist-type material which is removed by irradiation with an excimer laser which also causes deposition of seeds of palladium onto the irradiated parts of the substrate. The resist not removed can be left as a permanent resist which acts as an insulator between the subsequently electroless deposited copper lines.

Both of the above approaches have problems. Wet processes require complex sequences of chemical steps designed to produce active metallic species on the surface of a substrate such as an epoxy/glass composite. These processes require repeated exposure of the substrate to aqueous solutions which exacerbate problems associated with moisture pickup in the epoxy. Moisture pickup in the epoxy causes plasticizing of the epoxy and generally lowers its glass transition temperature. Also, aqueous solutions generally contain ionic contaminants which are left on the substrate surface after processing with these solutions. Such ionic contamination reduces the resistivity of the epoxy surface and can result in unwanted leakage current paths between metal lines on the epoxy surface. Moreover, these wet processes involve very sensitive chemistry and are prone to failure for reasons whose origin are often difficult to determine and correct. The dry process of the Baum et al. patent utilizes a laser technique which is complex to implement in a production line operation, as to do so would require a large expenditure for auxiliary equipment to step the laser beam across the printed circuit board in order to process metal lines.

It is an object of the present invention to provide a method for deposition onto the substrate surface from a vapor of a metal compound a species of the constituent metal of the metal compound.

It is another object of the present invention to provide an improved method of seeding a substrate.

These objects are achieved by a method as disclosed in claim 1.

It is acknowledged that the chemical reaction of organometallic compounds with chemically active sites, such a acids is commonly known in the art. See for example: Ward, M. D.; Schwartz, J., J. Am. Chem. Soc. 1981, pgs. 5253-5255; Huang, T.N.; Schwartz, J., J. Am. Chem. Soc. 1982, pgs. 3244-3245. It is also known in the art that some organometallic compounds are volatile. See for example: McClellan et al J. Am. Chem. Soc. 1961, pgs. 1601-1607.

The inventive method is a dry process for substrate seeding that uses conventional type tooling and conventional type process steps, thus avoiding complexity and high cost.

As used herein, the species of the constituent metal of the compound means: (1) a chemical compound of the constituent metal: (2) the constituent metal in a nonzero oxidation state; or (3) the constituent metal in the zero oxidation state.

In accordance with a more particular aspect of the present invention, the metallic chemical species, if not the zero oxidation state of the constituent metal, is then transformed into the zero oxidation state of the constituent metal which is bound to the substrate surface. Such a transformation can be accomplished by thermal decomposition, by chemical reduction, by exposing the substrate to atmospheric oxygen, and by exposure of a heated substrate to atmospheric oxygen. The zero oxidation state metal constituent adhering to the substrate surface is useful as a seed layer for electroless deposition by conventional means of the same metal or another metal.

Palladium is a particularly effective seed metal for electroless deposition of metals, especially copper. Particularly useful volatile organometallic compounds to practice the described invention are organopalladium compounds of which (cylopentadienyl)(allyl)palladium(II) and derivatives thereof and bis(allyl)palladium and derivatives thereof are examples.

In some applications it is desirable to form the seed material only on selected regions of the substrate and for this purpose preferably a resist-type material is used as a mask. A metal will then be electrolessly deposited only in the seeded regions. Furthermore, it may also be desirable to leave the resist in the regions not seeded. Such a permanent resist can function as an insulator between the electrolessly deposited metal lines. A process using a permanent resist is generally less complex since it does not require steps to remove the resist, and is less costly. Also, with a permanent resist process defects associated with the process steps necessary to remove the resist are eliminated, resulting in an improved process yield. However, the prior art processes for forming seed layers lead to problems when a permanent resist is to be formed.

In general, prior seeding techniques for electroless plating of advanced circuit boards involve deposition of the seed material over the entire surface of the board prior to application of the resist. The resist is then imaged and developed to expose selected seed-covered substrate regions where circuitry is desired. The exposed seed regions allow electroless plating of the desired circuit pattern, but the unexposed seed beneath the resist must be removed since it is conducting, and will be a source of electrical leakage current between plated metal lines. Thus, this approach does not allow the resist-layer to be left as a permanent resist, i.e., as a dielectric layer in the finished board.

In contrast with the prior seeding techniques, the present invention can use a permanent resist and avoid the problem of leaving metal seed under the permanent resist. After a substrate is sensitized with active chemical sites a resist type material is deposited onto the sensitized surface and selectively removed. The substrate is then contacted with a vapor of an organometallic compound. A species of the constituent metal of the compound, the constituent metal in an nonzero oxidation state or the constituent metal in the zero oxidation state adheres to the sensitized surface where the resist has been removed. The constituent metal species is transformed to free metal. Another metal is electrolessly deposed only onto the regions of the substrate to which the seed adheres.

Other advantageous embodiments of the inventive method are disclosed in the subclaims.

The inventive method will become more apparent from the following detailed description taken in conjunction with the accompanying drawings.
- Fig. 1: is a flow chart diagrammatically outlining the principal method steps for sensitizing and metallizing a substrate.
- Fig. 2: is a flow chart similar to that of Fig. 1, except that the substrate is metallized only in selected areas.

For convenience, the invention will be described in terms of preparing a printed circuit board for electroless deposition of copper onto a selectively deposited palladium seed layer. However, it should be understood that the invention extends to other materials and to many uses other than printed circuit boards. In general, the invention is suitable for any use wherein an electrolessly deposited adherent metal coating is applied to a suitable substrate such as a polymer i.e., an epoxy, a semiconductor, a ceramic or silica gel.

In the practice of this invention it is necessary to provide chemically active sites on a substrate which is then exposed to a vapor of an organometallic compound. These sites must react with the organometallic compound vapor to decompose it, at least, to a species of the metal constituent of the compound. This species must in turn be capable of being transformed to a zero oxidation state of the constituent metal or this species must be the zero oxidation state of the constituent metal. For the purposes of this invention, these sites are any type of localized regions of the substrate, or an entire surface of the substrate which will react with the organometallic compound vapor to cause the desired reaction. Examples of suitable chemically active sites are acid functionals and ammonia functionals.

The following will describe a known way for obtaining chemically active sites on an epoxy of the type used as a printed circuit board. These boards often have a copper cladding layer on at least one surface. This cladding layer is referred to as a sacrificial copper foil. Such a foil-clad substrate is manufactured by Gould Inc. of Mentor, Ohio and is marketed as Gould TC FOIL. One side of the sacrificial copper foil is smooth while the other side, which adheres to the substrate surface, has a rough texture. The rough side of the copper foil is usually coated with a material which promotes adhesion to the epoxy, for example chromate compounds. The rough side of the copper foil is laminated with the epoxy imparting to the epoxy a roughened surface. After subsequent etching of the copper foil the roughened epoxy surface provides the surface topography necessary for a subsequent electrolessly deposited metal, such as copper, to firmly adhere to the substrate. The sacrificial copper foil is etched away by chemicals such as cupric chloride, CuCl₂, and ferric chloride, FeCl₃. These chemical etchants do not remove the chrome compounds from the epoxy surface. Approximately 17 % of the epoxy surface is covered with chromic acids of a general formula known in the art as HₓCrO_{y}, where x and y have varying values depending on the valence state of the chrome ion. These chrome compounds are acidic and serve as active chemical sites on the epoxy surface.

In the present invention organometallic compounds which sublimate to the vapor phase can be used to provide the vapor which reacts with the chemically active sites on the epoxy substrate surface. A suitable apparatus and technique for doing this will now be described.

The substrate with the active chemical sites is placed in a chamber such as a glass jar or stainless steel jar which has a means to evacuate the chamber. The pressure in the chamber is lowered below atmospheric pressure for easy sublimation of the organometallic compounds. It has been found that 0.0133 mbar (0.01 torr) is satisfactory. This value is exemplary only and is not limiting. The organometallic compound is held in solid form in another isolated chamber which is connected to the chamber containing the substrate. When the chamber containing the organometallic compound is opened up to the substrate-containing chamber, it becomes filled with the organometallic vapor. The vapor contacting the substrate reacts with the chemically active sites.

The preferred embodiment of this invention uses volatile organopalladium compounds to cause palladium metal to be deposited on the substrate as a seed for subsequent electroless deposition of copper onto the seed. It is, of course, understood that the use of organopalladium compounds is only exemplary and is not limiting. Other organometallic compounds of which the metal constituent is an effective seed material can be used. It has been found that the substrate need be exposed to the vapor for only about 5 - 10 seconds to get a seed layer sufficient for in effective subsequent electroless deposition of copper. These times are exemplary and not limiting.

The preferred organopalladium compounds are (cyclopentadienyl)(allyl) palladium(II) represented by the chemical formula (C₅H₅)Pd(C₃H₅) and bis(allyl)palladium(II), represented by the chemical formula (C₃H₅)Pd(C₃H₅). Both of these compounds are volatile. Volatile derivatives of these compounds are also suitable. In derivatives of these compounds, all or any combinations of the hydrogen atoms of the two organic ligands - the allyl groups and the cyclopentadienyl groups - are substituted for by any organic or inorganic substituents. It is only necessary that the compounds sublimate to a vapor.

An organometallic compound useful for forming a seed layer for electroless deposition of a metal by the method of this invention must be volatile and the constituent metal must be active seed for the metal which is electrolessly deposited. Nickel, copper and palladium are active seed metals for electroless deposition of a metal such as copper.

Nickel carbonyl and diallylnickel(II) are examples of volatile organonickel compound useful for practicing this invention to deposit nickel seed. Nickel carbonyl is represented by the chemical formula Ni(CO)₄.

Diallylnickel(II) is represented by the chemical formula (n³-C₃H₅)₂Ni(II). A volatile organocopper compound useful for practicing this invention is copper(cyclopentadienyl)(triethylphosphine)(I) which is represented by the chemical formula (n⁵-C₅H₅) (P{C₂ H₅}₃)Cu(I). The term η^{x} indicates that x carbon atoms of the organic ligand are bound to the metal. These compounds and volatile derivatives thereof, formed by substituting all or any combination of hydrogen atoms with any organic or inorganic substituents, chemically react in a similar fashion to the organopalladium compounds referred to hereinabove.

The deposition of palladium metal from an organopalladium compound is easily effected due to the inherently weak nature of the bond between palladium and the organic ligands. This bond is weak enough to be broken in a variety of fashions. For instance, organopalladium compounds can be easily decomposed into another species by reaction with an acidic material. This usually results in the formation of a saturated organic ligand and a metal salt which adheres to the surface either chemically, physically, or by other means. Complete reduction of the metal does not always occur with this type of reaction. In this case, the reaction is useful to anchor a metal salt to suitably treated surfaces. A subsequent process step is used to reduce the metal salt to the metal constituent which adheres either chemically, physically, or by other ways to the surface. This metal is an effective seed layer for a subsequent electroless deposition of another metal such as copper, cobalt, palladium, nickel, silver, or gold. The preferred metal for a printed circuit board is copper.

The preferred palladium compounds (cyclopentadienyl)(allyl)palladium (II) and bis(allyl)palladium(II) possess the organic ligands needed for decomposition and appreciable volatility as well.

It is not necessary to start with copper clad epoxy to form acid functionals on the substrate surface. Acid functionals can be formed on an epoxy surface by treating this surface with an oxidizing solution such as chromic acid. This results in chromic acid either chemically or physically adhering to the epoxy surface or the formation of organic acids at the surface by the oxidation of the epoxy.

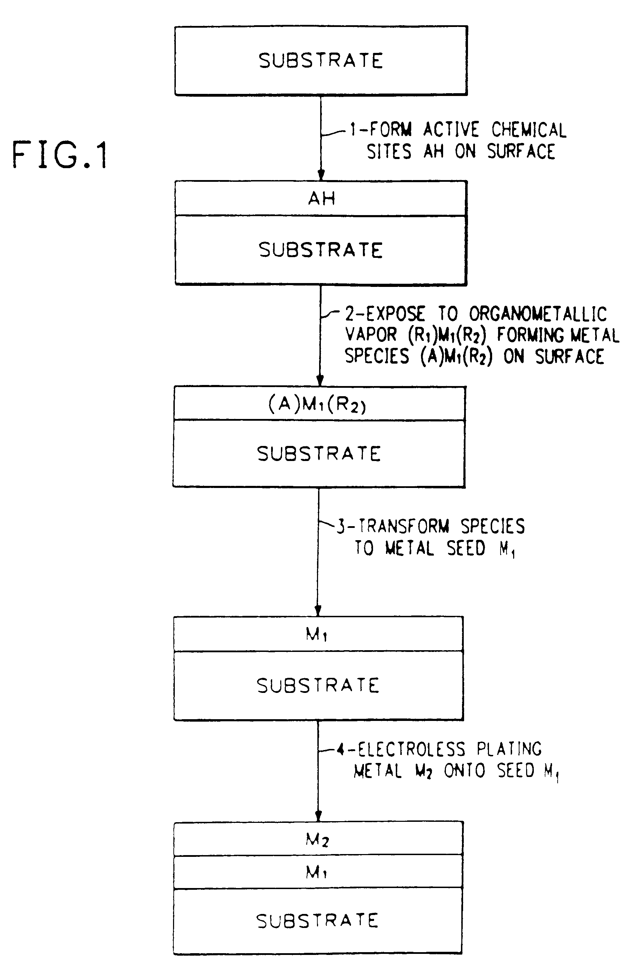

Known organometallic chemistry is represented by the following chemical reactions where M represents the metal species, L represents an organic ligand, n is the number of organic ligands, x is an element from the group fluorine, chlorine, bromine and iodine, RCO₂H represents an organic acid and Si-OH represents silica gel: 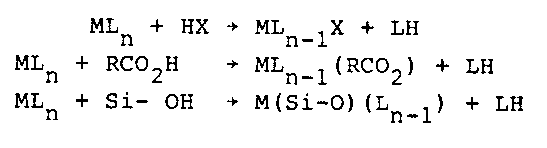
Fig. 1 diagrammatically outlines the principal method steps for sensitizing and metallizing a substrate. In step 1 active chemical sites are formed on the substrate surface. The active chemical site is represented in Fig. 1 as AH, where H is a hydrogen atom and A is a chemical constituent of the chemical site which adheres to the substrate surface. In step 2 the sensitized substrate is exposed to a vapor of an organometallic compound represented by (R₁)M₁(R₂) where R₁ and R₂ are organic ligands and M₁ is the constituent metal. The chemically active site AH chemically reacts with the vapor (R₁)M₁(R₂) to form a species of the organometallic compound referred to herein as a species of the constituent metal which is represented by AM₁(R₂). This species adheres to the substrate surface. A saturated organic ligand represented by R₁H is a second product of the chemical reaction. In step 3, the species of the constituent metal is transformed to the zero oxidation state of the constituent metal which also adheres to the substrate surface. The layer M₁ acts as a catalytic seed for electroless plating (Step 4) of another metal M₂ onto the seed layer M₁.

If the substrate surface sensitized with chromic acid is exposed to (cylopentadienyl)(allyl)palladium it is believed that one or both of the following chemical reactions occurs:

HₓCrO_{y} + (C₅H₅)Pd(C₃H₅) → (C₅H₅)Pd (Hₓ₋₁ CrO_{y}) + C₃H₆

HₓCrO_{y} + (C₅H₅)Pd(C₃H₅) → (C₃H₅)Pd (Hₓ₋₁ CrO_{y}) + C₅H₆

The palladium salt reaction product adheres to the substrate surface. The allyl ligand is protonated to propylene or the cyclopentadienyl ligand is protonated to cyclopentadiene.

If the substrate is exposed to a vapor of bis(allyl)palladium, the chemical reaction is the same except that the cyclopentadienyl ligand is replaced by an allyl ligand. The salt of the organopalladium compound adheres to the substrate surface since the Hₓ₋₁ CrO_{y} constituent adheres to the surface.

The organopalladium salt is transformed into palladium metal of the zero oxidation state which is the correct oxidation state for the palladium to act as a catalytic seed for the electroless deposition of a metal such as copper. This transformation can occur by chemical reduction, by thermal decomposition or by exposure to atmospheric oxygen. The preferred embodiment of this invention is to expose the epoxy substrate to atmospheric oxygen in combination with heating the substrate to a temperature between 50°C amd 60°C. Heat speeds up the transformation of the organopalladium salt to palladium metal.

As described above the substrate was exposed to the organopalladium vapor in a glass jar. The link connecting the solid organopalladium compound to the chamber holding the substrate is then closed. By means of a stopcock on the glass jar, the organopalladium vapor is removed and atmospheric oxygen is pumped into the glass jar. The substrate is then irradiated with a conventional infrared lamp to heat the substrate to a temperature less than the substrate transformation temperature but preferably in the range of 50°C and 60°C. The substrate transformation temperature is defined herein as the temperature at which the substrate degrades or physically changes, for example the melting point of the substrate. It is of course understood that these temperatures are exemplary and not limiting. Any means for heating the substrate can be used.

After the palladium metal seed is deposited, a metal such as copper, cobalt, palladium, nickel, silver, and gold is plated onto the seed by methods of electroless deposition commonly known in the art.

Another technique for creating active chemical sites on the substrate surface is to expose the substrate to an oxygen plasma. The preferred embodiment for this is an oxygen plasma of power density 0.3 Watts per cm² and pressure 133 µbar (100 millitorr). It is of course understood that these conditions are exemplary and not limiting.

An epoxy substrate is an organic material. On exposure to an oxygen plasma active chemical sites are formed on the epoxy surface. These sites are a type of organic acid which can be represented by RCO₂H, where R represents an organic constituent of the epoxy. The CO₂H constituent is acidic and chemically bound to the substrate surface. When a surface is sensitized this way and then exposed to a vapor of an organopalladium compound such as (cyclopentadienyl)(allyl)palladium, it is believed that one or both of the following chemical reactions occurs:

RCO₂H + (C₅H₅)Pd(C₃H₅) → (RCO₂)Pd(C₅H₅) + C₃H₆

RCO₂H + (C₅H₅)Pd(C₃H₅) → (RCO₂)Pd(C₃H₅) + C₅H₆

If the substrate is exposed to a vapor of bis(allyl) palladium the chemical reaction is the same except that the cyclopentadienyl ligand is replaced by an allyl ligand. The salt of the organopalladium compound is chemically bound to the substrate surface since the CO₂H constituent is bound to the surface. The organopalladium salt is transformed into a palladium seed layer as described above.

Functional sites which interact with an organometallic vapor can be formed on substrates other than epoxy substrates. For example, silica gel has hydroxyl groups (OH) chemically bound to silicon atoms at the silica gel surface. These OH groups act as acidic functional sites with which vapors of organopalladium compounds can react to form the organometallic salt. Referring to the organic acid example above, the hydrogen atom of the hydroxyl group at the silica gel surface acts in the same way as the hydrogen atom of the organic acid. The palladium metal salt is chemically bound to the oxygen atom of the hydroxyl group and a free saturated organic ligand is formed. This salt is transformed into the palladium metal seed by the same methods described above.

While the invention has been described in terms of forming active chemical sites on silica gel and organic substrates, such as an epoxy, it will be recognized by those of ordinary skill in the art that active chemical sites, such as hydroxyl groups, can be formed on other substrate surfaces, such as semiconductors and ceramics.

It is believed that an ammonia plasma will form active chemical sites on the substrate surface by imparting nitrogen functionalities, predominantly NH-- and NH₂-, on the substrate surface which are chemically, physically or by other means bound to the substrate surface. The substrate is exposed to a vapor of an organopalladium compound. The ammonia functionality at the surface may form a coordination complex with the palladium atom of the organopalladium compound. The palladium coordination complex adheres to the substrate surface since the ammonia ion does. The coordination complex is then transformed to palladium metal of the zero oxidation state by chemical reduction, thermal decomposition, exposure to atmospheric oxygen or exposure to atmospheric oxygen with the substrate at an elevated temperature. A metal, such as copper, is then plated onto the palladium metal seed by conventional electroless plating techniques.

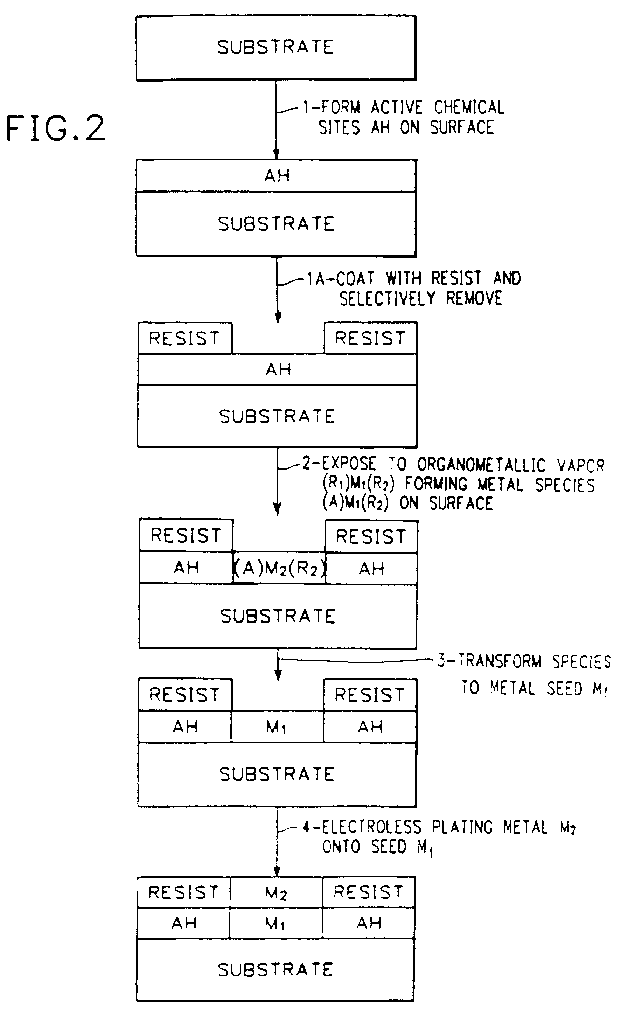

Fig. 2 diagrammatically outlines one particular preferred variation of the present invention. Steps 1, 2, 3 and 4 are the same as in Fig. 1. The symbols used in Fig. 1 and Fig. 2 have the same meanings. Fig. 2 has the additional step 1A which includes coating the substrate with a resist type material, such as a photoresist or polymer, after it is sensitized with active chemical sites. The resist is selectively removed by means commonly known in the art. Thus, only selected regions or parts of the sensitized substrate are exposed. When the substrate is exposed to the vapor of the organometallic compound, in particular organopalladium compounds, deposition of the salt of the organometallic compound occurs only on the exposed regions. For this purpose, a resist type material which does not have active chemical sites, such as acid functionals, must be used if the resist is to remain as a permanent dielectric layer on the substrate. When the salt of the organopalladium compound is transformed into palladium metal seed, the seed adheres to those regions of the substrate selectively exposed to the organometallic vapor. A metal such as copper is then electrolessly plated by conventional means onto the palladium metal seed forming metal lines on the substrate surface. Since palladium metal seed is deposited neither onto the resist nor under the resist there is no undesired resistive path between the copper metal lines. The resist remaining acts as a dielectric between the deposited copper metal lines.

The resist used to create the copper metal line pattern does not have to be left as a permanent resist. After electroless deposition of a metal, such as copper, onto the selectively deposited palladium seed, the resist can be removed by methods commonly known in the art.

When a nonpermanent resist is used, the resist can be removed prior to the electroless deposition of copper. Plating with the resist pattern on the substrate results in better quality rectangular shaped metal lines. After resist removal, a palladium metal seed pattern is left on the substrate onto which the copper can be electrolessly plated. In this case the resist material could have acid functional groups. Palladium metal would be formed on the resist. However, this would not create any undesired effects since, when the resist is removed, the palladium metal on it would also be removed.

Riston (registered Trademark of E. I. duPont de Nemours & Company) photoresist is an example of a resist with substantial chromic moiety. After removal of the Riston deposited on a substrate there is sufficient acid functionality on the substrate for effective chemical reaction with an organometallic vapor. Using this resist, a substrate surface does not have to be further sensitized with acid functionals in a separate step prior to deposition of the resist.

It is to be understood that the above described embodiments are simply illustrative of the principles of the invention. Various other modifications and changes may be devised by those skilled in the art.

## Claims

1. A method for preparing a substrate for subsequent metallization comprising the steps of:
forming active chemical sites adherent to the substrate surface, said active chemical sites having the property of being capable of chemically reacting with a volatile organometallic compound exposed to said sites and;
contacting a portion of said substrate surface with a vapor of said volatile organometallic compound for a time sufficient for said active sites to chemically react with said volatile organometallic compound, the chemical reaction releasing a saturated organic ligand from said organometallic compound and forming a second compound, which is a species of the constituent metal of said organometallic compound and which adheres to said substrate surface.

2. Method according to claim 1 further including the step of transforming said species of the constituent metal to said constituent metal adhering to the substrate surface.

3. Method according to claims 1 or 2 wherein the constituent metal of said organometallic compound is selected from the group consisting of nickel, copper and palladium.

4. Method according to any one of claims 1 to 3, wherein said active chemical sites are selected from the group consisting of acidic sites and sites of hydrogenated nitrogen.

5. Method according to any one of claims 1 to 4 wherein said organometallic compound is selected from the group consisting of a (cyclopentadienyl) (allyl)palladium(II) compound, a bis(allyl) palladium(II) compound, a nickel carbonyl compound, a diallynickel(II) compound and a (cyclopentadienyl) (triethylphosphine) copper(I) compound.

6. Method according to any one of claims 1 to 5 wherein said substrate is selected from the group consisting of polymers, epoxies, semiconductors and ceramics.

7. Method according to any one of claims 1 to 6 wherein said step of forming active chemical sites adherent to the substrate surface is followed by the step of covering the substrate with a resist-type material, followed by the step of selectively removing said resist material and subsequently contacting the substrate surface with an organometallic vapor, where said vapor contacts active chemical sites only in said exposed portion of said substrate surface.

8. Method according to any one of claims 1 to 7 further including the step of electrolessly depositing a metal onto those areas of the substrate to which said constituent metal adheres.

9. Method according to claim 8 wherein the electrolessly deposited metal is selected from the group consisting of copper, cobalt, palladium, nickel, silver and gold.

## Patentansprüche

1. Verfahren zur Herstellung eines Substrats für nachträgliche Metallisierung, das folgende Schritte umfaßt:
Bildung chemisch aktiver Stellen, die an der Substratoberfläche haften und die die Eigenschaft besitzen, daß sie bei Kontakt mit einer flüchtigen Organometallverbindung mit dieser reagieren können; und
Berührung eines Teils der Substratoberfläche mit einem Dampf der flüchtigen Organometallverbindung über einen ausreichend langen Zeitraum, damit die chemisch aktiven Stellen mit der flüchtigen Organometallverbindung reagieren, wobei die chemische Reaktion einen gesättigten organischen Liganden aus der Organometallverbindung freisetzt und eine zweite Verbindung bildet, die eine Spezies des Metallbestandteils der Organometallverbindung darstellt und die an der Substratoberfläche haftet.

2. Verfahren nach Anspruch 1, das ferner den Schritt einschließt, bei dem die Spezies des Metallbestandteils in den auf der Substratoberfläche haftenden Metallbestandteil umgesetzt wird.

3. Verfahren nach Anspruch 1 oder 2, bei dem der Metallbestandteil der Organometallverbindung aus der Gruppe ausgewählt wird, die aus Nickel, Kupfer und Palladium besteht.

4. Verfahren nach einem der Ansprüche 1 bis 3, bei dem die chemisch aktiven Stellen aus der Gruppe ausgewählt werden, die aus sauren Stellen und Stellen mit hydriertem Stickstoff besteht.

5. Verfahren nach einem der Ansprüche 1 bis 4, bei dem die Organometallverbindung aus der Gruppe ausgewählt wird, die aus einer (Cyclopentadienyl)(allyl)palladium(II)-Verbindung, einer Bis(allyl)palladium(II)-Verbindung, einer Nickelcarbonyl-Verbindung, einer Diallylnickel(II)-Verbindung und einer (Cyclopentadienyl)(triethylphosphin)kupfer(I)-Verbindung besteht.

6. Verfahren nach einem der Ansprüche 1 bis 5, bei dem das Substrat aus der Gruppe ausgewählt wird, die aus Polymeren, Epoxidharzen, Halbleitern und Keramiken besteht.

7. Verfahren nach einem der Ansprüche 1 bis 6, bei dem nach dem ersten Schritt, bei dem an der Substratoberfläche haftende chemisch aktive Stellen gebildet werden, in einem zweiten Schritt das Substrat mit einem Resiststoff bedeckt wird, und in einem dritten Schritt der Resiststoff selektiv entfernt wird und die Substratoberfläche anschließend einem Organometalldampf ausgesetzt wird, wobei nur die chemisch aktiven Stellen mit dem Dampf in Kontakt kommen, die sich in den ausgesetzten Bereichen der Substratoberfläche befinden.

8. Verfahren nach einem der Ansprüche 1 bis 7, das weiterhin den Schritt enthält, bei dem ein Metall stromlos auf den Bereichen des Substrats abgeschieden wird, auf denen der genannte Metallbestandteil haftet.

9. Verfahren nach Anspruch 8, bei dem das stromlos abgeschiedene Metall aus der Gruppe ausgewählt wird, die aus Kupfer, Cobalt, Palladium, Nickel, Silber und Gold besteht.

## Revendications

1. Procédé pour la préparation d'un substrat pour une métallisation ultérieure, comprenant les étapes de :
formation de sites chimiques actifs adhérents à la surface du substrat, ces sites actifs ayant la capacité de réagir chimiquement avec un composé organométallique volatil auquel sont exposés ces sites, et
mise en contact d'une partie de cette surface du substrat avec une vapeur de ce composé organométallique volatil pendant un temps suffisant pour que ces sites actifs réagissent chimiquement avec ce composé organométallique volatil, la réaction chimique libérant un ligand organique saturé à partir de ce composé organométallique et formant un second composé, qui est une espèce du métal constitutif de ce composé organométallique et qui adhère à cette surface du substrat.

2. Procédé suivant la revendication 1, comprenant de plus l'étape de transformation de cette espèce du métal constitutif en ce métal constitutif adhérant à la surface du substrat.

3. Procédé suivant les revendications 1 ou 2, dans lequel le métal constitutif de ce composé organométallique est choisi dans le groupe consistant en nickel, cuivre et palladium.

4. Procédé suivant l'une quelconque des revendications 1 à 3, dans lequel ces sites chimiques actifs sont choisis dans le groupe consistant en sites acides et sites d'azote hydrogéné.

5. Procédé suivant l'une quelconque des revendications 1 à 4, dans lequel ce composé organométallique est choisi dans le groupe consistant en un composé (cyclopentadiényl)(allyl)-palladium (II), un composé bis-(allyl)-palladium (II), un composé nickel-carbonyle, un composé diallyl-nickel (II) et un composé (cyclopentadiényl)(triéthylphosphine)-cuivre (I).

6. Procédé suivant l'une quelconque des revendications 1 à 5, dans lequel ce substrat est choisi dans le groupe consistant en polymères, résines époxy, semiconducteurs et céramiques.

7. Procédé suivant l'une quelconque des revendications 1 à 6, dans lequel cette étape de formation de sites chimiques actifs adhérant à la surface du substrat est suivie de l'étape de recouvrement du substrat avec une matière de type réserve, puis de l'étape d'élimination sélective de cette matière de réserve, et ensuite de la mise en contact de la surface du substrat avec une vapeur organométallique, la vapeur n'entrant en contact avec les sites chimiques actifs que dans cette partie exposée de cette surface du substrat.

8. Procédé suivant l'une quelconque des revendications 1 à 7, comprenant de plus l'étape de dépôt chimique d'un métal sur ces zones du substrat auxquelles adhère ce métal constitutif.

9. Procédé suivant la revendication 8, dans lequel ce métal déposé chimiquement est choisi dans le groupe consistant en cuivre, cobalt, palladium, nickel, argent et or.
